# EUROPEAN PATENT APPLICATION

(11) **EP 4 794 485 A1**
(43) Date of publication of application: **19.08.2026**
(21) Application number: 26158020.3
(22) Date of filing: 12.02.2026
(51) Int. Cl.: H10F 39/12, H10F 39/00

(54) **IMAGE SENSING DEVICE**

(30) Priority: 12.02.2025 KR 20250017986
(71) Applicant: SK hynix Inc., Bubal-eub Icheon-si Gyeonggi-do 17336 (KR)
(72) Inventor: DO, Young Woong, 17336 Icheon-si, Gyeonggi-do (KR); KIM, Won Jin, 17336 Icheon-si, Gyeonggi-do (KR)
(74) Representative: Isarpatent

(57) **Abstract**

An image sensing capable of improving characteristics of one or more miniaturized pixels is disclosed. The image sensing device includes: a substrate including photoelectric conversion regions, each photoelectric conversion region configured to generate photocharges corresponding to an intensity of incident light, the substrate having a light receiving surface through which the incident light enters the substrate to reach the photoelectric conversion regions; and a plurality of microlenses disposed above the light receiving surface of the substrate, each microlens having a top surface to receive incident light and a bottom surface that is opposite to the top surface. each of the microlenses is structured to have a focal distance greater than or equal to a limit focal distance associated with a distance between the light receiving surface of the substrate and the bottom surface of each of the microlenses.

## Description

### TECHNICAL FIELD

The technology and implementations disclosed in this patent document generally relate to an image sensing device capable of detecting light and a distance detection method for the same.

### BACKGROUND

An image sensing device is a device for capturing optical images by converting light into electrical signals using a photosensitive semiconductor material which reacts to light. With the development of automotive, medical, computer and communication industries, the demand for high-performance image sensing devices is increasing in various fields such as smartphones, digital cameras, game machines, IoT (Internet of Things), robots, security cameras and medical micro cameras.

Pixels, each of which is a unit circuit for detecting light in the image sensing devices, can be implemented in various ways depending on purposes or usages of the image sensing devices, and pixel miniaturization is emerging as an important issue in addition to the quality of images generated by the image sensing device.

### SUMMARY

Various embodiments of the present disclosure relate to an image sensing device capable of improving characteristics of one or more miniaturized pixels.

In accordance with an embodiment of the present disclosure, an image sensing device may include: a substrate including photoelectric conversion regions, each photoelectric conversion region configured to generate photocharges corresponding to an intensity of incident light, the substrate having a light receiving surface through which the incident light enters the substrate to reach the photoelectric conversion regions; and a plurality of microlenses disposed above the light receiving surface of the substrate, each microlens having a top surface to receive incident light and a bottom surface that is opposite to the top surface. each of the microlenses is structured to have a focal distance greater than or equal to a limit focal distance associated with a distance between the light receiving surface of the substrate and the bottom surface of each of the microlenses.

In accordance with another embodiment of the present disclosure, an image sensing device may include: a substrate including a photoelectric conversion region configured to generate photocharges corresponding to intensity of incident light, the substrate having a light receiving surface through which the incident light enters the substrate to reach the photoelectric conversion region; and a microlens disposed to overlap the photoelectric conversion region. The microlens has a radius of curvature that is greater than or equal to a value that is obtained by multiplying a limit focal distance having a value based on a distance between the light receiving surface of the substrate and a bottom surface of the microlens by a refractive index associated with a refractive coefficient of the microlens.

In accordance with another embodiment of the present disclosure, an image sensing device may include: a photoelectric conversion region configured to generate photocharges corresponding to intensity of incident light; and a microlens disposed to overlap the photoelectric conversion region to direct incident light to the photoelectric conversion region. The microlens has a flat top surface and a bottom surface that is opposite to the flat top surface, the bottom surface being closer to the photoelectric conversion region than the flat top surface.

It is to be understood that both the foregoing general description and the following detailed description of the present disclosure are illustrative and explanatory and are intended to provide further explanation of the disclosure as claimed.

### BRIEF DESCRIPTION OF THE DRAWINGS

The above and other features and beneficial aspects of the present disclosure will become readily apparent with reference to the following detailed description when considered in conjunction with the accompanying drawings.
FIG. 1 is a block diagram illustrating an example of an image sensing device based on some embodiments of the present disclosure.
FIG. 2A is a cross-sectional view illustrating an example of a pixel shown in FIG. 1 based on some embodiments of the present disclosure.
FIG. 2B is a cross-sectional view illustrating another example of the pixel shown in FIG. 1 based on some embodiments of the present disclosure.
FIG. 3 is a diagram illustrating design conditions for a microlens shown in FIGS. 2A and 2B based on some embodiments of the present disclosure.
FIG. 4A is a cross-sectional view illustrating another example of a pixel shown in FIG. 1 based on some embodiments of the present disclosure.
FIG. 4B is a cross-sectional view illustrating another example of a pixel shown in FIG. 1 based on some embodiments of the present disclosure.
FIG. 5 is a diagram illustrating design conditions for a light condensing structure shown in FIGS. 4A and 4B based on some embodiments of the present disclosure.

### DETAILED DESCRIPTION

This patent document provides embodiments and examples of an image sensing device capable of detecting light and a distance detection method for the same. Various implementations of the image sensing device and the distance detection method may be used in configurations to substantially address one or more technical or engineering issues and to mitigate limitations or disadvantages encountered in some image sensing devices in the art. Some embodiments of the present disclosure relate to an image sensing device capable of improving characteristics of one or more miniaturized pixels. In recognition of the issues above, the image sensing device according to the embodiments of the present disclosure may provide a pixel structure capable of maximizing light reception efficiency of a miniaturized pixel.

Reference will now be made in detail to the embodiments of the present disclosure, examples of which are illustrated in the accompanying drawings. Wherever possible, the same reference numbers will be used throughout the drawings to refer to the same or like parts. While the disclosure is susceptible to various modifications and alternative forms, specific embodiments thereof are shown by way of example in the drawings. However, the disclosure should not be construed as being limited to the embodiments set forth herein.

Hereinafter, various embodiments will be described with reference to the accompanying drawings. However, it should be understood that the present disclosure is not limited to specific embodiments, but includes various modifications, equivalents and/or alternatives of the embodiments. The embodiments of the present disclosure may provide a variety of effects capable of being directly or indirectly recognized through the present disclosure.

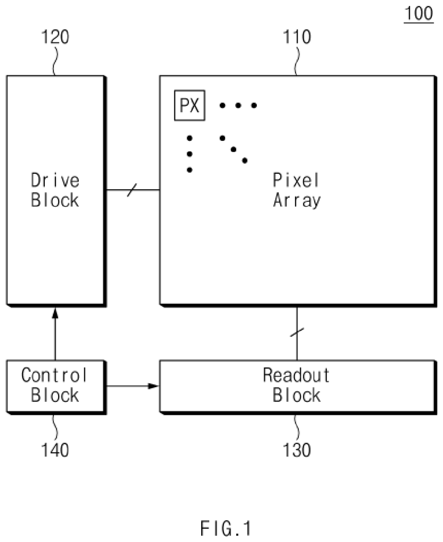

FIG. 1 is a block diagram illustrating an example of an image sensing device 100 based on some embodiments of the present disclosure.

Referring to FIG. 1, the image sensing device 100 may be implemented as a part of an imaging device. The imaging device may refer to a device, for example, a digital still camera for photographing still images or a digital video camera for photographing moving images. For example, the imaging device may be implemented as a Digital Single Lens Reflex (DSLR) camera, a mirrorless camera, or a smartphone, and others, but is not limited thereto. The imaging device may include a device having an image pickup element such that the device can capture (or photograph) a target object and can thus create an image of the target object.

The image sensing device 100 may be a Complementary Metal Oxide Semiconductor Image Sensor (CIS) that converts light into electrical signals. In some implementations, light may include photons that may cause the photoelectric effect. In addition, light may refer to electromagnetic radiation or electromagnetic waves corresponding to a specific wavelength band belonging to an electromagnetic spectrum that includes radio waves, microwaves, infrared light, near-infrared light, visible light, ultraviolet light, X-rays, and gamma rays.

The image sensing device 100 may include a pixel array 110, a drive block 120, a readout block 130, and a control block 140.

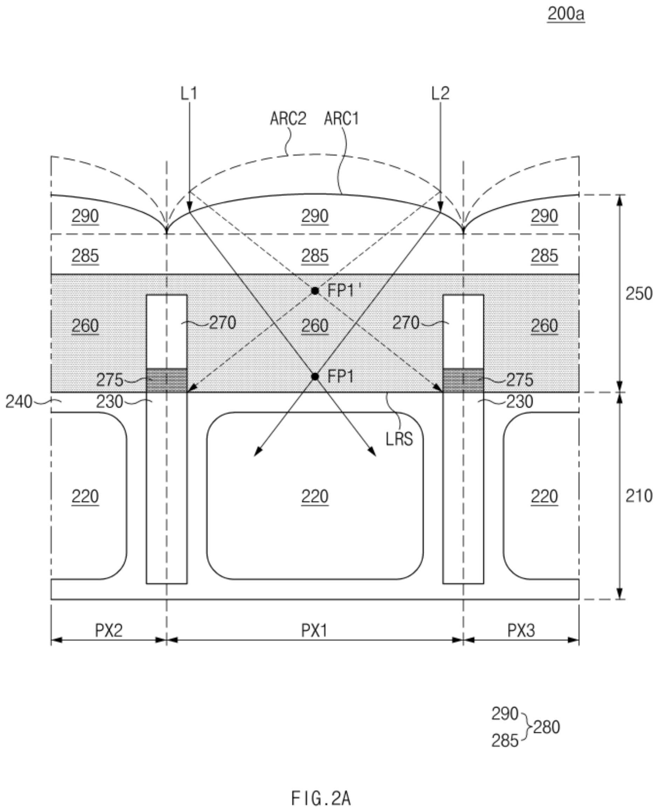

The pixel array 110 may include a plurality of pixels (PX) arranged sequentially in a matrix structure (for example, arranged sequentially in a column direction and/or a row direction). Each of the plurality of pixels (PXs) may generate a pixel signal by detecting incident light under the control of the drive block 120. The pixel signal may be a signal representing the number of photocharges generated according to the intensity of the incident light. The structure of each pixel (PX) will be described later with reference to FIG. 2A and below.

Pixels (PX) belonging to one row may receive the same pixel control signal from the drive block 120. Pixels (PXs) belonging to one column may be connected to one column line and may output pixel signals to the readout block 130. According to another embodiment, pixels (PXs) belonging to one column may be independently connected to different column lines and may output pixel data to the readout block 130.

The drive block 120 may drive the pixels (PXs) of the pixel array 110 in response to the timing signal output from the control block 140. For example, the drive block 120 may generate a control signal capable of selecting and controlling pixels (PXs) included in at least one row line from among a plurality of row lines of the pixel array 110.

The readout block 130 may detect a pixel signal output from the pixel array 110 under the control of the control block 140, and may output the detected pixel signal as image data. The image data may be digital data generated by performing an analog-to-digital conversion process on an analog pixel signal. To this end, the readout block 130 may include a correlated double sampler (CDS) for performing correlated double sampling on pixel signals output from the pixel array 110. In addition, the readout block 130 may include an analog-to-digital converter (ADC) for converting signals output from the correlated double sampler (CDS) into digital signals to generate pixel data. In addition, the readout block 130 may include a buffer circuit for temporarily storing pixel data output from the analog-to-digital converter (ADC) and outputting the stored pixel data to the outside under the control of the control block 140.

The control block 140 may generate a timing signal to control the drive block 120 and the readout block 130. In some implementations, the control block 140 may generate a timing signal according to a request from an external processor (e.g., an image signal processor ISP). In some implementations, the control block 140 may include a logic control circuit, a phase-locked loop (PLL) circuit, a communication interface circuit, etc.

FIG. 2A is a cross-sectional view 200a illustrating an example of a pixel shown in FIG. 1 based on some embodiments of the present disclosure.

Referring to FIG. 2A, the cross-section 200a of the pixel (PX) may be a cross-section obtained by cutting each pixel (PX) included in the pixel array 110 illustrated in FIG. 1 in one direction (e.g., a row direction or a column direction). Each of the first to third pixels (PX1~PX3) illustrated in FIG. 2A may correspond to the pixel (PX) of FIG. 1. Although the pixel structure is mainly described with respect to the first pixel (PX1) disposed between the second pixel (PX2) and the third pixel (PX3), the description provided for the first pixel (PX1) may also be applied to any other pixels (PX) included in the pixel array 110.

The cross-section 200a of the pixel may include a substrate layer 210 and a light incident layer 250 that are vertically stacked.

The substrate layer 210 may include a top surface and a bottom surface facing away or opposite to each other. The bottom surface of the substrate layer 210 may be defined as a front side, and the top surface of the substrate layer 210 may be defined as a back side, without being limited thereto. In addition, the top surface of the substrate layer 210 may be defined as a light receiving surface (LRS).

For example, the substrate layer 210 may be or include a semiconductor substrate. For example, the substrate layer 210 may be a bulk substrate (hereinafter referred to as an N-type bulk substrate) of a first conductive type (e.g., N-type) or a bulk substrate (hereinafter referred to as a P-type bulk substrate) of a second conductive type (e.g., P-type), may be a substrate formed by growing a first-conductive-type (N-type) or second-conductive-type (P-type) epitaxial layer on the first-conductive-type (N-type) bulk substrate, or may be a substrate formed by growing a first-conductive-type (N-type) or second-conductive-type (P-type) epitaxial layer on the second-conductive-type (P-type) bulk substrate.

The substrate layer 210 may include a photoelectric conversion region 220, a device isolation structure 230, and a silicon region 240. The substrate layer 210 may also be referred to as a substrate.

The photoelectric conversion region 220 may generate and accumulate photocharges corresponding to the intensity of incident light. The photoelectric conversion region 220 may be formed as a doped region including impurities (e.g., N-type impurities) of the first conductivity type (e.g., N-type) through an ion implantation process that implants ions of the first conductivity type (e.g., N-type). In some implementations, the photoelectric conversion region 220 may be formed in a shape in which a plurality of doped regions is stacked. In this case, the lower doped region may be formed by implanting N+-type ions, and the upper doped region may be formed by implanting N--type ions. The photoelectric conversion region 220 may be arranged to occupy as large a region as possible to increase a fill factor indicating light reception (Rx) efficiency.

A device isolation structure 230 may be disposed at a boundary between adjacent pixels (e.g., PX1 and PX2 or PX1 and PX3), and may be formed to be deeply etched in a vertical direction, so that the device isolation structure 230 may electrically or optically isolate the adjacent pixels from each other. The device isolation structure 230 may be formed as a frontside deep trench isolation (FDTI) structure or a backside deep trench isolation (BDTI) structure. An insulation layer (e.g., a silicon oxide layer, a silicon nitride layer, or the like) may be disposed in the device isolation structure 230. In some implementations, the insulation layer may include a polysilicon material to which a bias voltage for suppressing dark current can be applied.

The silicon region 240 may be a region including impurities of the first conductive type or impurities of the second conductive type.

The light incident layer 250 may receive incident light (e.g., L1, L2) from the outside of the image sensing device 100, and may transmit the received incident light to the substrate layer 210. The light incident layer 250 may include one or more optical filters 260, one or more air grid structures 270, one or more metal grid structures 275, one or more lens base layers 285, and one or more microlenses 290.

The optical filter 260 may be disposed on or over the photoelectric conversion region 220. The optical filter 260 may receive the incident light and selectively transmit light (e.g., red light, green light, blue light, magenta light, yellow light, cyan light, infrared (IR) light, or others) based on its transmission wavelength band. In this case, the transmission wavelength band may refer to a wavelength band of light that is to be selectively transmitted by the corresponding optical filter 260. For example, the optical filter 260 of the first pixel (PX1) may have a transmission wavelength band corresponding to a green light and selectively transmit the green light. The optical filter 260 may include a colored photosensitive material corresponding to a specific color, or may include thin film layers that are alternately arranged. In the example of FIG. 2A, the optical filter 260 is illustrated as being disposed to contact the substrate layer 210. However, other implementations are also possible. For example, , an anti-reflection layer (not illustrated) may be placed between the substrate layer 210 and the optical filter 260 to reduce light reflection from the light receiving surface (LRS).

The air grid structure 270 and the metal grid structure 275 may be disposed along a boundary between adjacent pixels (e.g., PX1 and PX2 or PX1 and PX3) to minimize optical crosstalk between the adjacent pixels. The air grid structure 270 may be disposed over the metal grid structure 275.

The air grid structure 270 may include air having a refractive index (e.g., 1) lower than a refractive index (e.g., 1.7 to 1.8) of the optical filter 260. The side surface of the air grid structure 270 may reflect light that is incident obliquely through the optical filter 260 back toward the optical filter 260. The air grid structure 270 may include a capping layer (not shown) surrounding the air for morphological stability and process convenience.

According to another embodiment, the air grid structure may be replaced with a low-refractive-index grid structure including a low-refractive-index material other than air. The low-refractive-index material may be a material having a lower refractive index than a refractive index of the optical filter 260.

The metal grid structure 275 may include a metal (e.g., tungsten) having a high light absorption rate. The metal grid structure 275 may absorb light that is incident through the optical filter 260 or the air grid structure 270.

The air grid structure 270 and the metal grid structure 275 may have substantially the same width as shown in FIG. 2A, but the scope of the present disclosure is not limited thereto. Although the width of each of the air grid structure 270 and the metal grid structure 275 may be the same as the width of the device isolation structure 230, other implementations are also possible, and the width of each of the air grid structure 270 and the metal grid structure 275 may be larger or smaller than the width of the device isolation structure 230.

The lens base layer 285 may be arranged on the optical filter 260 and may include a photoresist material having high transparency. The lens base layer 285 may be formed integrally with the microlens 290. For example, the lens base layer 285 may refer to a photoresist material that remains unused after the photoresist material is exposed to form the microlens 290 and a lens molding process (e.g., etch back, thermal reflow, etc.) is then performed.

The microlens 290 may be arranged on the lens base layer 285 (i.e., the upper side of the substrate layer 210), and may increase light gathering power for incident light to improve light reception efficiency of the photoelectric conversion region 220. The lens base layer 285 and the microlens 290 may be collectively referred to as the lens layer 280.

In some implementations, it is assumed that the microlens 290 has a circular segment shape (e.g., arcuate shape) including a bottom surface corresponding to a chord and a top surface (ARC1) corresponding to an arc.

The microlens 290 may have a predetermined radius of curvature to increase light gathering power, and the top surface (ARC1) of the microlens 290 may have a curvature corresponding to the radius of curvature of the microlens 290. As illustrated in FIG. 2A, it is assumed that the first light (L1) and the second light (L2) incident upon the microlens 290 are light incident at positions symmetrical to each other with respect to the optical axis of the microlens 290. In the example as shown in FIG. 2A, the first light (L1) may be light incident at a position close to (or identical to) the boundary between the first pixel (PX1) and the second pixel (PX2) on the top surface (ARC1) of the microlens 290. In the example as shown in FIG. 2A, the second light (L2) may be light incident at a position close to (or identical to) the boundary between the first pixel (PX1) and the third pixel (PX3) on the top surface (ARC1) of the microlens 290. In the example, the positions on the top surface (ARC1) of the microlens, where the first light (L1) and the second light (L2) are incident, are symmetrical to each other with respect to the optical axis of the microlens 290. The first light (L1) and the second light (L2) may meet at a first focal point (FP1) after passing through the microlens 290 and may be incident toward the photoelectric conversion region 220.

In some implementations, as the radius of curvature of the microlens 290 decreases, light gathering power for the incident light may increase. This is because when the radius of curvature of the microlens 290 decreases, the incident light can be refracted at a larger angle toward the optical axis of the microlens 290.

FIG. 2A illustrates an example that the microlens 290 is formed to have a radius of curvature smaller than the radius of curvature corresponding to the top surface (ARC1). In this case, as illustrated in FIG. 2A, the microlens 290 has an upper surface (ARC2). When the microlens 290 is formed to have the upper surface (ARC2) instead of the top surface (ARC1), the first light (L1) and the second light (L2) may meet at a first focal point (FP1') after passing through the microlens 290.

Since the first focal point (FP1') is located above the first focal point (FP1), the first light (L1) and the second light (L2) meet at the first focal point (FP1') after passing through the microlens 290, and are not directly incident upon the photoelectric conversion region 220, but are incident upon and absorbed into the metal grid structure 275. As a result, the quality of image data generated by the image sensing device 100 may be degraded as the light reception efficiency of the photoelectric conversion region 220 is degraded.

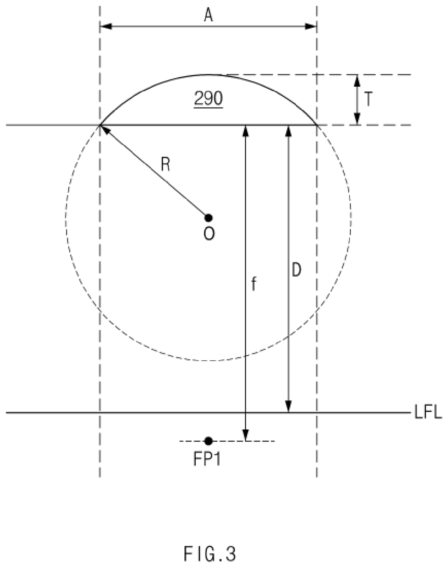

Therefore, in order to prevent the light reception efficiency of the photoelectric conversion region 220 from being degraded, the microlens 290 may be required to satisfy predetermined design conditions, and these design conditions will be described later with reference to FIG. 3.

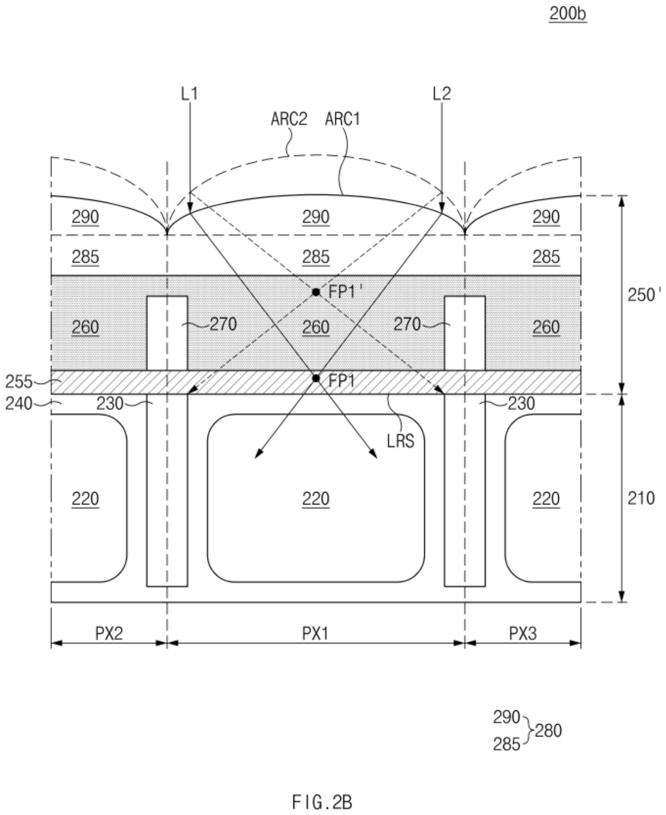

FIG. 2B is a cross-sectional view 200b illustrating another example of the pixel shown in FIG. 1 based on some embodiments of the present disclosure.

Referring to FIG. 2B, the cross-section 200b of the pixel (PX) may be a cross-section obtained by cutting each pixel (PX) included in the pixel array 110 illustrated in FIG. 1 in one direction (e.g., a row direction or a column direction). Each of the first to third pixels (PX1~PX3) illustrated in FIG. 2B may correspond to the pixel (PX) of FIG. 1. Although FIG. 2B illustrates the pixel structure that is described with a focus on the first pixel (PX1) disposed between the second pixel (PX2) and the third pixel (PX3), other implementations are also possible, and this pixel structure may also be applied to any pixel (PX) included in the pixel array 110.

The cross-section 200b of the pixel may include a substrate layer 210 and a light incident layer 250' that are vertically stacked. The cross-section 200b of the pixel is substantially the same as the cross-section 200a of the pixel described in FIG. 2A except for some differences therebetween, and as such redundant description thereof will herein be omitted for brevity.

Unlike the light incident layer 250 of FIG. 2A, the light incident layer 250' of FIG. 2B may not include the metal grid structure 275 and may include the anti-reflection layer 255.

The anti-reflection layer 255 may be disposed on the top surface of the substrate layer 210 and may be disposed below the optical filter 260 and the air grid structure 270. For example, the anti-reflection layer 255 may be disposed between the top surface of the substrate layer 210 and the optical filter 260, and may be disposed between the top surface of the substrate layer 210 and the air grid structure 270.

The anti-reflection layer 255 may have a refractive index that is lower than the refractive index of the optical filter 260 and higher than the refractive index of the silicon region 240. Accordingly, the anti-reflection layer 255 may reduce reflection of light incident from the optical filter 260 toward the silicon region 240.

According to one embodiment, the anti-reflection layer 255 may include a silicon oxide layer and/or a silicon nitride layer, but the scope of the present disclosure is not limited thereto.

FIG. 2B illustrates an example that the microlens 290 is formed to have a radius of curvature smaller than the radius of curvature corresponding to the top surface (ARC1). As illustrated in FIG. 2B, the microlens 290 has another top surface (ARC2). In this case, the first light (L1) and the second light (L2) may meet at the first focal point (FP1') after passing through the microlens 290.

Since the first focal point (FP1') is located above the first focal point (FP1), the first light (L1) and the second light (L2) meet at the first focal point (FP1') after passing through the microlens 290, and are not directly incident upon the photoelectric conversion region 220, but are incident into the space between the top surface of the substrate layer 210 and the air grid structure 270, and may leak to adjacent pixels (e.g., PX2, PX3). As a result, the light reception efficiency of the photoelectric conversion region 220 is degraded and crosstalk may occur, so that the quality of image data generated by the image sensing device 100 may also be degraded.

Therefore, in order to prevent a decrease in the light reception efficiency of the photoelectric conversion region 220 and occurrence of such crosstalk, the microlens 290 may be required to satisfy predetermined design conditions, and these design conditions will be described later with reference to FIG. 3.

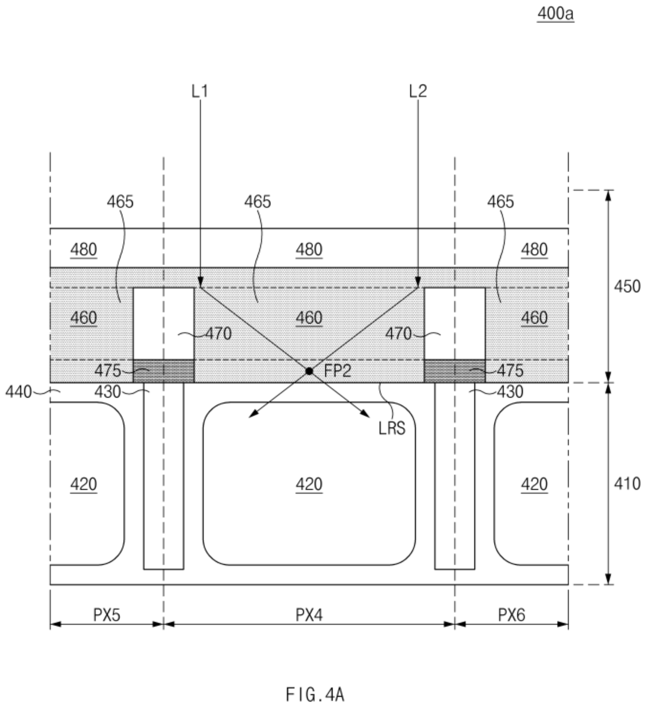

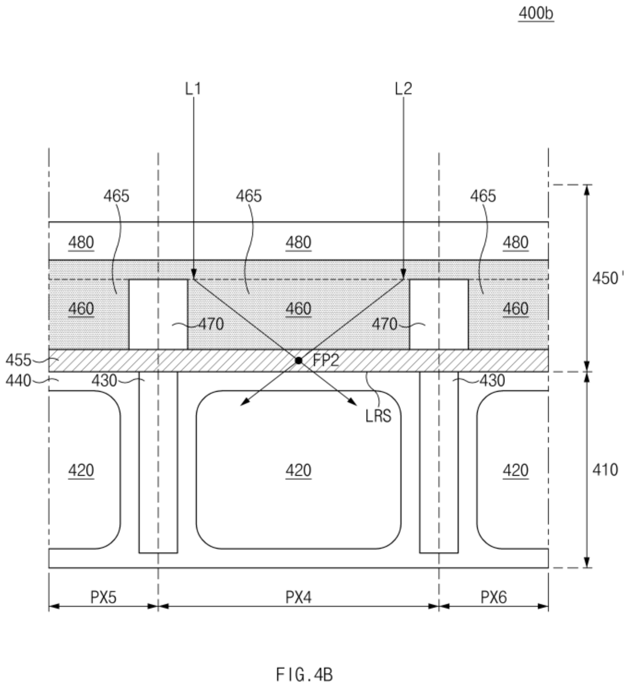

FIG. 3 is a diagram illustrating design conditions for the microlens shown in FIGS. 2A and 2B based on some embodiments of the present disclosure. A microlens 290 in FIG. 3 may be structured in various configurations. In the illustrated example in FIG. 3, can have a curved convex surface (e.g., a convex spherical surface with a radius R) on one side and a flat surface on the opposite side to collect incident light from the convex curved surface and to output focused light from the flat surface. In other implementations, e.g., in the example in FIG. 4A or 4B, the microlens may have flat surfaces.

Referring to FIG. 3, the example of the microlens 290 as illustrated may have a circular or spherical segment shape (arcuate shape) forming a portion of a circle or a sphere. The radius of the circle including the microlens 290 may mean the radius of curvature (R) of the curved surface of the microlens 290. The radius may correspond to a distance from the origin (O) of the circle to any point of the circle or sphere.

A thickness (T) of the microlens 290 may be defined as a distance between the bottom surface (a flat chord) of the microlens 290 and the uppermost end of the top curved surface (arc) of the microlens 290. A width (A) of the microlens 290 may be defined as a distance between the left and right ends of the top surface (arc) of the microlens 290. The width (A) of the microlens 290 may be equal to the width of the first pixel (PX1) in order to cover the first pixel for directing incident light into the first pixel.

FIG. 3 illustrates an example of a limit focal line (LFL) of a specific example of the microlens 290 having a curved convex surface and a flat surface on the opposite sides. As illustrated, the focal length of the microlens 290 is f and a first focal point FP1 is shown. When the microlens 290 is used direct incident light to the first pixel (PX1) to achieve its required light reception efficiency, the incident light may be focused onto various possible focal points that of the microlens 290 depending on the conditions of the incidence of the incident light (e.g., the incident directions of the incident light). The limit focal line (LFL) may refer to a straight line that passes through a particular focal point having the shortest distance from the microlens 290 out of the various focal points for satisfying the light reception efficiency required for the first pixel (PX1). The limit focal line (LFL) may be experimentally determined in consideration of the light reception efficiency required for the first pixel (PX1) during a design process or test process of the image sensing device 100.

As illustrated in FIG. 3, the distance between the limit focal line (LFL) and the microlens 290 is labeled as a limit focal distance (D). The limit focal distance (D) may be a value related to the distance between the light receiving surface (LRS) of the substrate layer 210 and the flat bottomsurface of the microlens 290. See, e.g., FIG. 2A or 2B and FIG. 3. For example, the limit focal distance (D) may increase as the distance between the light receiving surface (LRS) of the substrate layer 210 and the bottom surface of the microlens 290 increases. In addition, the limit focal distance (D) may become smaller as the distance between the light receiving surface (LRS) of the substrate layer 210 and the lower surface of the microlens 290 decreases.

In one embodiment, the limit focal distance (D) may be the same as or approximate to the distance between the light receiving surface (LRS) of the substrate layer 210 and the bottom surface of the microlens 290.

In another embodiment, the limit focal distance (D) may be the same as or approximate to a value obtained by subtracting the height of the metal grid structure 275 from the distance between the light receiving surface (LRS) of the substrate layer 210 and the bottom surface of the microlens 290.

The limit focal distance (D) may refer to a minimum value of the focal distance where light having penetrated the microlens 290 can satisfy the light reception efficiency required for the first pixel (PX1) without being absorbed in the metal grid structure 275 or without shifting to an adjacent pixel.

If the focal distance of the microlens 290 is shorter than the limit focal distance (D) (i.e., the focal point of the microlens 290 is located above the limit focal line LFL), the microlens 290 is unable to satisfy the light reception efficiency required for the first pixel (PX1) because the focused light output by the microlens 290 in this example begins to diverge or spread after passing through the focal point before reaching to the photoelectric conversion region 220 of the pixel underneath the microlens 290.

On the other hand, if the focal distance of the microlens 290 is longer than the limit focal distance (D) (i.e., the focal point of the microlens 290 is located below the limit focal line LFL), the microlens 290 may satisfy the light reception efficiency required for the first pixel (PX1).

The focal distance (f) of the first focal point (FP1) of the microlens 290 exemplified in FIGS. 2A, 2B, and 3 is longer than the limit focal distance (D), so that the microlens 290 may satisfy the light reception efficiency required for the first pixel (PX1).

For the microlens 290 with a spherical surface as shown in FIG. 3, if the refractive index of the microlens 290 is defined as 'n', the relationship between the focal distance (f) and the radius of curvature (R) in a spherical circular segment shape where the radius of curvature of one surface of a double-sided lens is infinite may be derived from the lens maker's formula as shown in Equation 1 below.$\frac{1}{f} = \left(n-1\right) \frac{1}{R}$

The design conditions for satisfying the light reception efficiency required for the first pixel (PX1) by rearranging Equation 1 with respect to the focal distance (f) may be expressed as Equation 2 below.$D \leq f = \frac{R}{\left(n-1\right)}$

In order to satisfy the light reception efficiency required for the first pixel (PX1), the focal distance (f) should be greater than or equal to the limit focal distance (D). In addition, according to the relationship between the focal distance (f) and the radius of curvature (R) according to Equation 1, the condition of the radius of curvature (R) for satisfying the light reception efficiency required for the first pixel (PX1) can be rearranged as shown in Equation 3 below.$R \geq \left(n-1\right) D$

The radius of curvature (R) of the microlens 290 may be required to be greater than or equal to the value obtained by multiplying the limit focal distance (D) by (n-1), where '(n-1)' may be defined as a refractive coefficient related to the refractive index (n) of the microlens 290.

In the implementations, the radius of curvature (R), thickness (T), and width (A) of the microlens 290 may have a relationship as shown in Equation 4 due to geometrical characteristics of the microlens 290.$R = \frac{T}{2} + \frac{{A}^{2}}{8 T}$

In a situation where the radius of curvature (R) of the microlens 290 is fixed to a specific value to satisfy the light reception efficiency required for the first pixel (PX1), when the width (A) that determines the size of the first pixel (PX1) is reduced, the thickness (T) should be reduced so that the radius of curvature (R) of the microlens 290 can be maintained.

In some embodiments, when microlenses having different sizes (e.g., a first microlens and a second microlens having a width larger than that of the first microlens) are arranged in the pixel array 110, the thickness of the second microlens having a relatively large width may be greater than the thickness of the first microlens having a relatively small width.

If the thickness (T) of the microlens 290 is fixed to a specific value due to the process limit of the microlens 290 (for example, if the microlens 290 must be formed through a single process), when the width (A) that determines the size of the first pixel (PX1) is reduced, the radius of curvature (R) of the microlens 290 is also reduced. However, the reduced radius of curvature (R) needs to satisfy Equation 3 in order to satisfy the light reception efficiency required for the first pixel (PX1).

in some implementations, the pixel array 110 may have microlenses having different sizes. For example, when microlenses having different sizes (i.e., a first microlens and a second microlens having a larger width than that of the first microlens) are arranged in the pixel array 110, the radius of curvature of the second microlens having a relatively large width may be larger than the radius of curvature of the first microlens having a relatively small width.

When the width of the pixel becomes very small (e.g., 0.56 µm or less), the diffraction phenomenon becomes severe and optical crosstalk increases, which may lead to a decrease in the light reception efficiency of the corresponding pixel. Therefore, when the width of the pixel included in the pixel array 110 is very small (e.g., 0.56 µm or less), the radius of curvature of the first microlens having a relatively small width may be larger than the radius of curvature of the second microlens having a relatively large width. This is to reduce the diffraction phenomenon by increasing the radius of curvature of the microlens arranged in the corresponding pixel as the width of the pixel becomes smaller. In this case, the thickness of the first microlens may be smaller than the thickness of the second microlens. Meanwhile, in order to reduce the diffraction phenomenon, the thickness of the first microlens and the thickness of the second microlens may be limited to a limit thickness (e.g., 1500 Å) related to the width of the pixel (e.g., 0.56 µm).

According to one embodiment, the first microlens may be arranged to cover one photoelectric conversion region, and the second microlens may be arranged to cover a plurality (e.g., two or four) of photoelectric conversion regions, but the scope of the present disclosure is not limited thereto. When the first microlens is arranged to cover one photoelectric conversion region and the second microlens is arranged to cover multiple photoelectric conversion regions, the first microlens and the second microlens are arranged over different pixels without being overlapped to each other.

FIG. 4A is a cross-sectional view 400a illustrating another example of the pixel shown in FIG. 1 based on some embodiments of the present disclosure.

Referring to FIGS. 2A and 4A, the cross-section 400a of the pixel may be a cross-section obtained by cutting each pixel (PX) included in the pixel array 110 illustrated in FIG. 1 in one direction (e.g., a row direction or a column direction). Each of the fourth to sixth pixels (PX4~PX6) illustrated in FIG. 4A may correspond to the pixel (PX) of FIG. 1. Although the pixel structure is mainly described with respect to the fourth pixel (PX4) disposed between the fifth pixel (PX5) and the sixth pixel (PX6), the description provided for the fourth pixel (PX4) may also be applied to any other pixels (PX) included in the pixel array 110.

The cross-section 400a of the pixel may include a substrate layer 410 and a light incident layer 450 that are vertically stacked.

The structure and function of the substrate layer 410 and the light incident layer 450 are substantially the same as the structure and function of the substrate layer 210 and the light incident layer 250 shown in FIG. 2A except for some differences therebetween, and as such redundant description thereof will herein be omitted for brevity.

In some implementations, the structures and functions of the photoelectric conversion region 420, the device isolation structure 430, and the silicon region 440 of the substrate layer 410 may be similar to or substantially the same as those of the photoelectric conversion region 220, the device isolation structure 230, and the silicon region 240 of the substrate layer 210 as discussed with regard to FIG. 2A.

The light incident layer 450 may include an optical filter 460, an air grid structure 470, a metal grid structure 475, and a lens layer 480.

The lens layer 480 may correspond to the lens base layer 285 and the microlens 290 shown in FIG. 2A. The top surface of the lens layer 480 (or microlens) may be exposed to the outside as a flat surface. Thus, in the example in FIG. 4A, the lens layer 480 may include a microlens having a flat top surface with an infinite radius of curvature for receiving incident light and a flat bottom surface for exporting focused light towards a photoelectric conversion region 420.

The air grid structure 470 may have a relatively large width than the air grid structure 270 of FIG. 2A, and the metal grid structure 475 may have a relatively large width than the metal grid structure 275 of FIG. 2A. As illustrated in FIG. 4A, the width of each of the air grid structure 470 and the metal grid structure 475 may be larger than the width of the device isolation structure 430, but the scope of the present disclosure is not limited thereto. According to another embodiment, the width of each of the air grid structure 470 and the metal grid structure 475 may be the same as the width of the device isolation structure 430 or may be smaller than the width of the device isolation structure 430.

The air grid structure 470 and the metal grid structure 475 may have substantially the same width for structural stability, but according to another embodiment, the width of the air grid structure 470 may be larger or smaller than the width of the metal grid structure 475. When the width of the air grid structure 470 is larger than the width of the metal grid structure 475, the degree of absorption of incident light by the metal grid structure 475 may be reduced. When the width of the air grid structure 470 is smaller than the width of the metal grid structure 475, structural stability may be further improved.

The optical filter 460 may include a filter region 465 that is disposed between adjacent air grid structures 470 and has the same height as the air grid structure 470. In the cross-section 400a of FIG. 4A, the air grid structure 470 and the filter region 465 may be alternately disposed in the horizontal direction. In the fourth pixel (PX4), the filter region 465 may be disposed at the center of the fourth pixel (PX4), and the air grid structures 470 may be disposed on the left and right sides of the filter region 465.

The filter region 465 may be or include a dense region having a relatively high refractive index (e.g., 1.6 to 1.8), and the air grid structure 470 may be or include a rare region having a relatively low refractive index (e.g., 1). Thus, the filter region 465 and the air grid structures 470 disposed at the left and right sides of the filter region 465 may form a light condensing structure (hereinafter referred to as a "(rare-dense-rare) light condensing structure") in which a rare region, a dense region, and a rare region are arranged sequentially.

The light condensing structure may correspond to a diffraction grating structure. The diffraction grating structure may be a structure in which slits through which light can pass are periodically arranged in a light blocking layer through which light cannot pass. The filter region 465 may correspond to a slit, and the air grid structure 470 may correspond to a light blocking layer. The air grid structure 470 is a structure in which air having a relatively low refractive index is surrounded by a capping layer having a relatively high refractive index, and may reflect most of light obliquely incident toward the top surface of the air grid structure 470, so that the air grid structure 470 may correspond to a light blocking layer. The filter region 465 may correspond to a slit that transmits the incident light downward without reflecting the incident light.

In order for the light condensing structure composed of the filter region 465 and the air grid structure 470 to function as a diffraction grating structure, the width of the filter region 465, which is the width of the slit, and the period at which the slit is repeated (i.e., the width of the pixel (e.g., PX4)) may be required to be sufficiently small to be close to the wavelength (e.g., about 400 nm to 700 nm) of visible light. The width or period of the slit may be experimentally determined so that the light condensing structure can function as a diffraction grating structure. In order for the light condensing structure to function as a diffraction grating structure, in FIG. 4A, the width of the filter region 465 corresponding to the slit may be made small so that the width of the air grid structure 470 may be relatively large.

Since the light incident layer 450 includes a microlens having a flat surface, the first light (L1) and the second light (L2) incident toward the fourth pixel (PX4) are not refracted toward the center line of the fourth pixel (PX4), but can be incident upon the top surface of the air grid structure 470 included in the light condensing structure.

The first light (L1) and the second light (L2) having penetrated the light condensing structure may meet at the second focal point (FP2), and may be incident toward the photoelectric conversion region 420.

If the light condensing structure does not function as a diffraction grating structure, the first light (L1) and the second light (L2) may not be focused on the photoelectric conversion region 420 but may travel in the same direction as the incident light, so that the first light (L1) and the second light (L2) may be scattered at an interface (e.g., the top surface of the substrate layer 410) or absorbed into an adjacent structure (e.g., the metal grid structure 475) and may not reach the photoelectric conversion region 420. Thus, as the light reception efficiency of the photoelectric conversion region 420 decreases, the quality of the image data generated by the image sensing device 100 may deteriorate.

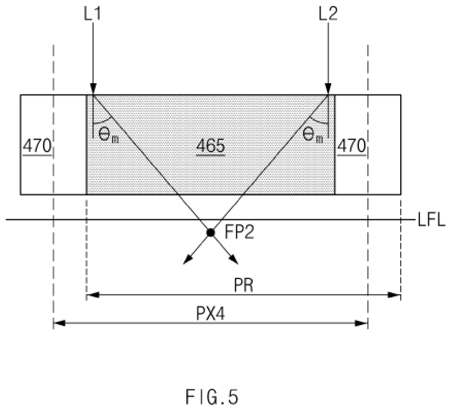

Therefore, in order to prevent deterioration of the light reception efficiency of the photoelectric conversion region 420, the light condensing structure including the air grid structure 470 may be required to satisfy predetermined design conditions, and these design conditions will be described later with reference to FIG. 5.

Although the embodiment of FIG. 4A exemplarily shows the pixel structure in which the light condensing structure is arranged when the lens layer 480 includes a flat microlens, other implementations are also possible. For example, the light condensing structure may also be arranged even when the lens layer 280 includes the microlens 290 having a predetermined curvature as shown in FIG. 2A.

FIG. 4B is a cross-sectional view 400b illustrating another example of the pixel shown in FIG. 1 based on some embodiments of the present disclosure.

Referring to FIG. 4B, the cross-section 400b of the pixel (PX) may be a cross-section obtained by cutting each pixel (PX) included in the pixel array 110 illustrated in FIG. 1 in one direction (e.g., a row direction or a column direction). Each of the fourth to sixth pixels (PX4~PX6) illustrated in FIG. 4B may correspond to the pixel (PX) of FIG. 1. Although FIG. 4B illustrates the pixel structure that is described with a focus on the fourth pixel (PX4) disposed between the fifth pixel (PX5) and the sixth pixel (PX6), other implementations are also possible, and this pixel structure may also be applied to any pixel (PX) included in the pixel array 110.

The cross-section 400b of the pixel may include a substrate layer 410 and a light incident layer 450' that are vertically stacked. The cross-section 400b of the pixel is substantially the same as the cross-section 400a of the pixel described in FIG. 4A except for some differences therebetween, and as such redundant description thereof will herein be omitted for brevity.

Unlike the light incident layer 450 of FIG. 4A, the light incident layer 450' of FIG. 4B may not include the metal grid structure 275 and may include the anti-reflection layer 455.

The anti-reflection layer 455 may be disposed on the top surface of the substrate layer 410 and may be disposed below the optical filter 460 and the air grid structure 470. For example, the anti-reflection layer 455 may be disposed between the top surface of the substrate layer 410 and the optical filter 460, and may be disposed between the top surface of the substrate layer 410 and the air grid structure 470.

The anti-reflection layer 455 may have a refractive index that is lower than the refractive index of the optical filter 460 and higher than the refractive index of the silicon region 440. Accordingly, the anti-reflection layer 455 may reduce reflection of light incident from the optical filter 460 toward the silicon region 440.

According to one embodiment, the anti-reflection layer 455 may include a silicon oxide layer and/or a silicon nitride layer, but the scope of the present disclosure is not limited thereto.

Since the light incident layer 450 includes a microlens having a flat surface, the first light (L1) and the second light (L2) incident toward the fourth pixel (PX4) may not be refracted toward the center line of the fourth pixel (PX4) but may be incident upon the top surface of the air grid structure 470 included in the light condensing structure.

The first light (L1) and the second light (L2) having penetrated the light condensing structure may meet at the second focal point (FP2) and may be incident toward the photoelectric conversion region 420.

If the light condensing structure does not function as a diffraction grating structure, the first light (L1) and the second light (L2) may not be focused on the photoelectric conversion region 420 but may travel in the same direction as the incident light, so that the first light (L1) and the second light (L2) may be scattered at the interface (e.g., the top surface of the substrate layer 410) or may leak into an adjacent space (e.g., a space between the top surface of the substrate layer 410 and the air grid structure 470). As a result, the first light (L1) and the second light (L2) may not reach the photoelectric conversion region 420. In other words, as the light reception efficiency of the photoelectric conversion region 420 decreases, the quality of the image data generated by the image sensing device 100 may deteriorate.

Therefore, in order to prevent deterioration of the light reception efficiency of the photoelectric conversion region 420, the light condensing structure including the air grid structure 470 may be required to satisfy predetermined design conditions, and these design conditions will be described later with reference to FIG. 5.

Although the embodiment of FIG. 4B exemplarily shows the pixel structure in which the light condensing structure is arranged when the lens layer 480 includes a flat microlens, other implementations are also possible, and the light condensing structure may also be arranged even when the lens layer 280 includes the microlens 290 having a predetermined curvature as shown in FIG. 2B.

FIG. 5 is a diagram illustrating design conditions for the light condensing structure shown in FIGS. 4A and 4B based on some embodiments of the present disclosure.

Referring to FIG. 5, a filter region 465 corresponding to the light condensing structure included in the fourth pixel (PX4) and a plurality of air grid structures 470 disposed at the left and right sides of the filter region 465 are illustrated.

The incident light incident upon the light condensing structure functioning as a diffraction grating structure may satisfy Equation 5 below.$PR \left({sinθ}_{i}+{sinθ}_{m}\right) = mλ$

In Equation 5, θi of the incident light may denote an angle of incidence, θm may denote a transmission angle through which the incident light passes through the light condensing structure, and PR may denote a pixel period. The pixel period (PR) may be a period in which pixels are repeated or a period in which the filter region 465 corresponding to a slit is repeated. In addition, 'm' may be a diffraction order, and 'λ' may be a wavelength of the incident light.

The first light (L1) and the second light (L2) perpendicularly incident upon the light condensing structure may have an angle of incidence (θi) of 0 degrees. When the transmission angle (θm) for each of the first light (L1) and the second light (L2) is rearranged using Equation 5, the resultant transmission angle (θm) can be rearranged as Equation 6 below.${sinθ}_{m} = \frac{mλ}{PR}$

According to Equation 6, as the wavelength (λ) of the incident light increases within the range of 0 to 90 degrees (0° to 90°), the transmission angle (θm) may increase, and as the pixel period (PR) increases, the transmission angle (θm) may decrease.

The first light (L1) and the second light (L2) incident upon the light condensing structure can be refracted (or diffracted) to have the transmission angle (θm) and meet at the second focal point (FP2). As illustrated in FIG. 5, when the second focal point (FP2) is located below the limit focus line (LFL), the light condensing structure may satisfy the light reception efficiency required for the fourth pixel (PX4). The diffraction order of the light illustrated in FIG. 5 may be a diffraction order of the absolute value of 1, but the scope of the present disclosure is not limited thereto.

The pixel period (PR) for allowing the second focal point (FP2) to be located below the limit focus line (LFL) may be experimentally determined in consideration of the wavelength (λ) of the incident light. In addition, the filter region 465 may have as wide a width as possible to maximize the light reception region, but may be experimentally determined to be within a threshold value for the filter region 465 and the air grid structures 470 to function as a diffraction grating structure.

According to one embodiment, the pixel period (PR) may vary depending on the wavelength (λ) of the incident light having penetrated the filter region 465. For example, if the incident light having penetrated the filter region 465 is red light having a relatively long wavelength, the light condensing structure may have a relatively large pixel period (PR). Conversely, if the incident light having penetrated the filter region 465 is blue light having a relatively long wavelength, the light condensing structure may have a relatively small pixel period (PR). Additionally, if the incident light having penetrated the filter region 465 is green light having an intermediate wavelength, the light condensing structure may have an intermediate pixel period (PR). Due to these design conditions, the pixels of the pixel array 110 may have overall uniform light reception efficiency.

According to the present disclosure, since the light condensing structure included in the filter region 465 and the air grid structures 470 disposed at the left and right sides of the filter region 465 functions as a diffraction grating structure, the amount of light traveling at a specific angle increases, thereby obtaining a desired light condensing effect even without using the microlens.

As is apparent from the above description, the image sensing device according to the embodiments of the present disclosure can provide a pixel structure capable of maximizing light reception efficiency of a miniaturized pixel.

The embodiments of the present disclosure may provide a variety of effects capable of being directly or indirectly recognized through the above-mentioned patent document.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and/or illustrated in this patent document.

## Claims

1. An image sensing device, comprising:
a substrate including photoelectric conversion regions, each photoelectric conversion region configured to generate photocharges corresponding to an intensity of incident light, the substrate having a light receiving surface through which the incident light enters the substrate to reach the photoelectric conversion regions; and
a plurality of microlenses disposed above the light receiving surface of the substrate, each microlens having a top surface to receive incident light and a bottom surface that is opposite to the top surface,
wherein
each of the microlenses is structured to have a focal distance greater than or equal to a limit focal distance associated with a distance between the light receiving surface of the substrate and the bottom surface of each of the microlenses.

2. The image sensing device according to claim 1, wherein:
the top surface of the microlens is a convex surface with a radius of curvature being greater than or equal to a value that is obtained by multiplying a refractive index of the microlens by the limit focal distance.

3. The image sensing device according to claim 1, wherein:
the value of the limit focal distance is equal to a distance between the light receiving surface of the substrate and the bottom surface of the microlens.

4. The image sensing device according to claim 1, further comprising:
a metal grid structure disposed over the substrate; and
wherein
the value of the limit focal distance is obtained by subtracting a height of the metal grid structure from the distance between the light receiving surface of the substrate and the bottom surface of the microlens.

5. The image sensing device according to claim 1, wherein the plurality of microlenses includes:
a first microlens; and
a second microlens having a larger width than a width of the first microlens.

6. The image sensing device according to claim 5, wherein:
the first microlens is disposed to cover a first photoelectric conversion region of the photoelectric conversion regions; and
the second microlens is disposed to cover two or more other photoelectric conversion regions than the first photoelectric conversion region.

7. The image sensing device according to claim 5, wherein:
the first microlens includes a convex surface with a radius of curvature being equal to a radius of curvature of a curved surface of the second microlens; and
a thickness of the first microlens is smaller than a thickness of the second microlens.

8. The image sensing device according to claim 5, wherein:
a thickness of the first microlens is equal to a thickness of the second microlens; and
the first microlens includes a curved surface with a radius of curvature smaller than a radius of curvature of a curved surface of the second microlens.

9. The image sensing device according to claim 5, wherein:
the first microlens includes a curved surface with a radius of curvature larger than a radius of curvature of the second microlens.

10. The image sensing device according to claim 1, wherein:
the microlens has a structure with an infinite radius of curvature.

11. The image sensing device according to claim 1, wherein:
the microlens includes a flat top surface.

12. The image sensing device according to claim 10, further comprising:
an optical filter disposed below the microlens to filter light to be received by the photoelectric conversion regions in the substrate; and
an air grid structure including air and disposed to contact the optical filter at a boundary between a pixel including a photoelectric conversion region overlapping the microlens and an adjacent pixel.

13. The image sensing device according to claim 12, further comprising:
a device isolation structure disposed inside the substrate at the boundary,
wherein
the air grid structure has a larger width than a width of the device isolation structure.

14. The image sensing device according to claim 12, wherein:
the optical filter disposed below the microlens includes a filter region disposed on a side of the air grid structure,
wherein
the optical filter is configured to allow the incident light that is incident vertically upon the filter region to refract from a top surface of the filter region toward the photoelectric conversion region.

15. The image sensing device according to claim 1, wherein
the microlens has a radius of curvature that is greater than or equal to a value that is obtained by multiplying the limit focal distance by a refractive index associated with a refractive coefficient of the microlens.
